# EUROPÄISCHE PATENTSCHRIFT

(11) **EP 2 347 932 B1**
(45) Veröffentlichungstag und Bekanntmachung des Hinweises auf die Patenterteilung: **09.05.2012**
(21) Anmeldenummer: 10150791.1
(22) Anmeldetag: 14.01.2010
(51) Int. Cl.: B60Q 11/00, G01R 31/02, H05B 33/08

(54) **Ausfallerkennung elektrischer Verbraucher in Kraftfahrzeugen**
Malfunction recognition for electricity consumers in motor vehicles
Consommateur électrique de reconnaissance d'une panne dans des véhicules automobiles

(43) Veröffentlichungstag der Anmeldung: 27.07.2011
(73) Patentinhaber: SMR Patents S.à.r.l., 1653 Luxembourg (LU)
(72) Erfinder: Fried, Udo, 71336, Waiblingen (DE)
(74) Vertreter: Weber-Bruls, Dorothée

(56) Entgegenhaltungen:
- DE-A1- 19 806 821
- US-A1- 2004 004 483
- US-A1- 2004 145 838
- US-B1- 6 307 376

## Beschreibung

Die Erfindung betrifft eine Ausfallerkennung gemäß dem Oberbegriff des Anspruchs 1.

In elektrischen Stromkreisen, wie sie beispielsweise in Kraftfahrzeugen zum Betrieb von Beleuchtungseinrichtungen, wie etwa Leuchten, Scheinwerfern und Lampen, zum Betrieb von Stellgliedern, wie etwa elektrisch verstellbarer Außenrückblickspiegel, elektrischer Fensterheber, elektrischer Sitzverstelleinrichtungen und elektrischer bzw. elektronischer Schließmechanismen, sowie zum Betrieb von Antriebsmotoren, wie etwa von Pumpen, Lüftern und Kompressoren vorgesehen sind, um nur einige denkbare Varianten zu nennen, sind ein oder mehrere elektrische Verbraucher angeordnet, deren Funktion bzw. deren unangekündigte Nichtfunktion oder deren unerwarteter Ausfall sicherheitsrelevant sein kann.

Deshalb wird angestrebt, elektrische Verbraucher im Stromkreis auf deren Funktion und/oder deren Nichtfunktion und/oder deren Ausfall hin zu überwachen, beispielsweise um im Falle einer zu erwartenden Nichtfunktion, eines durch Augenschein nicht unmittelbar erkennbaren Ausfalls oder einer Funktionseinschränkung eine Warnung beispielsweise an den Fahrer eines Kraftfahrzeugs auszugeben. Diese Art der Überwachung wird allgemein als Ausfallerkennung bezeichnet.

Die Ausfallerkennung umfasst dabei neben einer Betriebsüberwachung vermehrt auch eine Ruheüberwachung, bei der eine zu erwartende Funktion oder Nichtfunktion oder ein Ausfall erkannt wird, während der Verbraucher nicht betrieben wird und sich in Ruhe befindet. Neben Kurzschluss und Durchbrand findet außerdem vermehrt auch Berücksichtigung, dass ein elektrischer Verbraucher nicht nur durch eigenes Versagen sondern auch durch eine als Open-Load bezeichnete Unterbrechung der kurz auch als Anschluss bezeichneten Anschlussleitungen ausfallen kann. Open-Load ist dabei von einem absichtlichen, mittels eines Schalters vorgenommenen Unterbrechen des Anschlusses zu unterscheiden, da der Verbraucher mittels eines Schalters aktiv von der Stromversorgung getrennt und ausgeschaltet wird, wohingegen bei einer Unterbrechung des Anschlusses eine unbeabsichtigte und damit unvorhersehbare Nichtfunktion des Verbrauchers vorliegt.

Durch US 7,280,333 B2 ist eine Ausfallerkennung elektrischer Verbraucher bekannt. Die Ausfallerkennung stellt zunächst fest, ob sich ein ohmscher Verbraucher oder dessen Anschluss in einem normalen Betriebszustand oder in einem fehlerhaften Zustand befindet. Wird ein fehlerhafter Zustand festgestellt, bestimmt die Ausfallerkennung anschließend, ob es sich dabei um Open-Load, um einen Kurzschluss gegen Masse oder um einen Kurzschluss gegen Versorgungsspannung bzw. Phase handelt. Die Ausfallerkennung sieht ferner vor, bei festgestelltem fehlerhaftem Zustand einen Parameter des elektrischen Verbrauchers zu verändern, um dem fehlerhaften Zustand zu entkommen. Beispielsweise werden die Richtung und/oder die Stärke eines in den oder aus dem ohmschen Verbraucher fließenden Stroms verändert. Die Ausfallerkennung umfasst hierzu einen Detektionsstromkreis, der mit einem Messpunkt verbunden ist. An dem Messpunkt ist ein zur Ausfallerkennungsüberwachung vorgesehener elektrischer Verbraucher gegen Masse angeschlossen. Der Detektionsstromkreis hat zwei Komparatoren, einem Schalter, zwei regelbare Stromquellen und eine Verbindungsleitung zum Messpunkt. Mit der Verbindungsleitung verbunden sind die zwei regelbaren Stromquellen, von denen die eine gegen Masse und die andere gegen Versorgungsspannung regelbar ist. Der Schalter ist mit einer Seite mit der Verbindungsleitung verbunden. An die andere Seite des Schalters sind jeweils ein Eingang jeweils eines Komparators angeschlossen, so dass die beiden Komparatoren mit einem Eingang miteinander verbunden sind und mittels des Schalters wahlweise über die Verbindungsleitung mit dem Messpunkt verbunden werden können. Der verbleibende freie Eingang des einen Komparators ist mit Masse, der freie Eingang des anderen Komparators mit Versorgungsspannung verbunden. Um festzustellen, ob sich ein ohmscher Verbraucher oder dessen Anschluss in einem normalen Betriebszustand oder in einem fehlerhaften Zustand befindet, wird der Schalter geschlossen, so dass die Komparatoren mit dem Messpunkt verbunden sind. Die Komparatoren überwachen dabei, ob die Spannung des Messpunkts unterhalb eines unteren Schwellenwerts oder oberhalb eines oberen Schwellenwerts liegt. Die Ausgänge werden abgetastet, wobei ein fehlerfreier normaler Betriebszustand vorliegt, wenn die Ausgänge beider Komparatoren niedrig bzw. Null sind, und ein fehlerhafter Zustand vorliegt, wenn einer der Ausgänge hoch bzw. Eins ist. Wird ein fehlerhafter Zustand festgestellt, so wird durch eine anhand der regelbaren Stromquellen herbeigeführte Veränderung einer vorgegebenen Richtung und einer vorgegebenen Stärke eines in den oder aus dem Messpunkt fließenden Stroms bestimmt, ob es sich dabei um Open-Load, um einen Kurzschluss gegen Masse oder um einen Kurzschluss gegen Versorgungsspannung bzw. Phase handelt. Die Komparatoren dienen dabei bei geschlossenem Schalter wiederum einer Überwachung, ob die Spannung des Messpunkts unterhalb des unteren Schwellenwerts oder oberhalb des oberen Schwellenwerts liegt. Liegt die Spannung unterhalb des unteren Schwellenwerts liegt ein Kurzschluss des ohmschen Verbrauchers mit Masse vor. Liegt die Spannung oberhalb des oberen Schwellenwerts wird versucht, Strom in den Messpunkt fließen zu lassen, um die Spannung des Messpunkts unter den oberen Schwellenwert fallen zu lassen. Gelingt dies, liegt Open-Load vor. Gelingt dies nicht und bleibt die Spannung über dem oberen Schwellenwert liegt ein Kurzschluss des Verbrauchers mit Versorgungsspannung vor.

Nachteilig hieran ist der hohe Aufwand sowohl für den Detektionsstromkreis mit seinen vielen komplexen und kostspieligen Komponenten selbst, als auch zur zeitlichen und logischen Steuerung der Komponenten des Detektionsstromkreises und der Abfragealgorithmen zur Durchführung und Auswertung der zweistufigen Ausfallerkennung.

Durch die DE 10 2004 045 435 B4 ist eine Ausfallerkennung mit einer vergleichsweise einfachen Schaltung bekannt. Dabei wird der Strom bzw. die

Leistungsaufnahme eines elektrischen Verbrauchers überwacht und durch Vergleich mit einem oberen, einem mittleren und einem unteren Schwellenwert entschieden, ob ein Kurzschluss vorliegt, eine Glühbirne als Verbraucher betrieben wird, eine Leuchtdiode als Verbraucher betrieben wird, oder ob kein Strom fließt und demnach der Verbraucher durchgebrannt ist. Der obere Schwellenwert ist hierzu bei 50 W festgelegt, oberhalb dem vom Vorliegen eines Kurzschlusses ausgegangen wird. Der mittlere Schwellenwert ist bei 10 W festgelegt, wobei bei einer Leistungsaufnahme zwischen 10 W und 50 W von einem Glühlampenbetrieb ausgegangen wird. Der untere Schwellenwert liegt bei 0,1 W, wobei bei einer Leistungsaufnahme zwischen 0,1 W und 10 W von einem Leuchtdiodenbetrieb ausgegangen wird. Unterhalb einer Leistungsaufnahme von 0,1 W wird von einem Defekt des elektrischen Verbrauchers ausgegangen. Ziel der Ausfallerkennung ist, bei Leuchtdiodenbetrieb z.B. einer Wiederholblinkleuchte eines Kraftfahrzeugs einen elektrischen Widerstand zuzuschalten, so dass ohne Umrüstmaßnahmen bzw. bei beliebiger Verwendbarkeit von Leuchtdioden oder Glühlampen aus Sicht eines Steuergeräts des Kraftfahrzeugs eine ausreichend hohe Leistungsentnahme vorliegt, um von einem normalen Glühlampenbetrieb auszugehen, und nach wie vor ein Ausfall durch Kurzschluss oder Durchbrand bzw. Nichtfunktion erkannt wird.

Ein wesentlicher Nachteil dieser Ausfallerkennung ist deren hohe Verlustleistung z.B. bis zur Erkennung eines Kurzschlusses.

Durch DE 10 2008 042 595 B3 ist eine Ausfallerkennung bekannt, die ebenso dazu dient, Leuchtdioden als Leuchtmittel in bestehende Kraftfahrzeuge einzusetzen, ohne Umrüstmaßnahmen durchführen zu müssen. Hierbei wird jedoch eine Leistungsentnahme konventioneller Leuchtmittel nicht durch einen Widerstand hergestellt, der die nicht benötigte Leistung schlicht verheizt, sondern es wird statt dessen eine Leistungsentnahme simuliert, indem die für den Betrieb von beispielsweise Leuchtdioden im Vergleich zu Glühlampen nicht benötigte elektrische Leistung dem Bordnetz eines Kraftfahrzeugs an einer Stelle entzogen und an anderer Stelle wieder zugeführt wird.

Nachteile dieser Ausfallerkennung sind die hohen fließenden Ströme verbunden mit einer entsprechend kostspieligen Dimensionierung der elektrischen Anschlussleitungen.

US20040004483 A1 offenbart eine Schaltung mit zwei Schalter und einem parallel zu beiden Schaltern liegenden Spannungsteiler. Die Ausfallerkennung wird über den Vergleich mehrerer Potentiale in einer Vergleichseinheit erreicht.

US20040145838 A1 offenbart eine Schaltung, in der über mehrere Schalter einen Vielzahl an Potentialen abgegriffen wird, um den Ausfall eines Motors zu detektieren.

Eine Aufgabe der Erfindung ist es eine Ausfallerkennung für beliebige elektrische Verbraucher in einem Kraftfahrzeug zu entwickeln, welche sämtliche Ausfallarten zu erkennen in der Lage ist und welche in ihrem Aufbau und in ihrem Ablauf einfach und kostengünstig verwirklicht werden kann.

Die Aufgabe wird gelöst durch die Merkmale des Anspruchs 1.

Eine Ausfallerkennung elektrischer Verbraucher in Kraftfahrzeugen sieht demnach mindestens einen elektrischen Verbraucher vor, der schaltbar zwischen zwei unterschiedlichen elektrischen Potentialen, einem ersten elektrischen Potential und einem zweiten elektrischen Potential angeordnet ist. Der elektrische Verbraucher ist sowohl mit dem ersten, als auch mit dem zweiten Potential schaltbar verbunden. Ein erster Schalter ist zwischen dem ersten Potential und dem Verbraucher und ein zweiter Schalter ist zwischen dem zweiten Potential und dem Verbraucher angeordnet. Zum Betrieb des Verbrauchers müssen der erste und der zweite Schalter gleichzeitig geschlossen sein. Die Ausfallerkennung erfolgt in augenscheinlich ausgeschaltetem Zustand des Verbrauchers. Parallel zum zweiten Schalter ist ein Spannungsteiler angeordnet an dem ein drittes elektrisches Potential abgegriffen wird. Dieses dritte elektrische Potential dient als Überwachungsgröße und wird zur Ausfallerkennung beobachter. Die Ausfallerkennung erfolgt durch Beobachtung des als Überwachungsgröße dienenden dritten elektrischen Potentials und der Stellungen des ersten und des zweiten Schalters.

Wichtig ist hervorzuheben, dass die Ausdrücke erstes, zweites und drittes Potential, erster und zweiter Schalter sowie allgemein die Begriffe erste, zweite, dritte keine Reihenfolge bezeichnen, sondern lediglich einer Unterscheidung dienen und beliebig austauschbar sind.

Mit der Erfindung erzielte Vorteile sind, dass eine hierfür erforderliche Schaltungsanordnung mit nur geringem Aufwand kostengünstig verwirklicht werden kann.

Vorzugsweise identifiziert die Ausfallerkennung die unterschiedlichen Ausfallarten
a) Open-Load;
b) verbraucherseitiger Kurzschluss des ersten Schalters mit dem zweiten Potential bzw. Kurzschluss der Verbindung zwischen dem ersten Schalter und dem Verbraucher mit dem zweiten Potential, beispielsweise wenn ein bei geschlossenem ersten Schalter durch diesen fließender Strom einen vorgegebenen Stromschwellenwert übersteigt;
c) Kurzschluss zwischen dem ersten und dem zweiten Schalter bzw. Kurzschluss der Verbindung zwischen dem ersten Schalter und dem Verbraucher mit der Verbindung zwischen dem zweiten Schalter und dem Verbraucher, beispielsweise wenn bei geschlossenem ersten und geschlossenem zweiten Schalter ein durch den ersten Schalter fließender Strom den vorgegebenen Stromschwellenwert übersteigt, oder wenn bei geschlossenem ersten Schalter und bei geöffnetem zweiten Schalter die Spannung des dritten Potentials gegenüber dem zweiten Potential über einem vorgegebenen ersten Spannungsschwellenwert liegt, welcher beispielsweise der Spannung des ersten Potentials gegenüber dem zweiten Potential abzüglich eines spannungsteilerspezifischen Spannungsabfalls entsprechend kann;
d) verbraucherseitiger Kurzschluss des ersten Schalters mit dem ersten Potential bzw. Kurzschluss der Verbindung zwischen dem ersten Schalter und dem Verbraucher mit dem ersten Potential, beispielsweise wenn der erste und der zweite Schalter geöffnet sind und die Spannung des dritten Potentials gegenüber dem zweiten Potential über einem vorgegebenen zweiten Spannungsschwellenwert liegt, welcher beispielsweise der Spannung des ersten Potentials gegenüber dem zweiten Potential abzüglich eines verbraucherspezifischen Spannungsabfalls und abzüglich einem spannungsteilerspezifischen Spannungsabfall entsprechen kann;
e) verbraucherseitiger Kurzschluss des zweiten Schalters mit dem zweiten Potential bzw. Kurzschluss der Verbindung zwischen dem zweiten Schalter und dem Verbraucher mit dem zweiten Potential, beispielsweise wenn der erste Schalter geschlossen und der zweite Schalter geöffnet ist und die Spannung des dritten Potentials gegenüber dem zweiten Potential unterhalb einem vorgegebenen dritten Spannungsschwellenwert liegt;
f) verbraucherseitiger Kurzschluss des zweiten Schalters mit dem ersten Potential bzw. Kurzschluss der Verbindung zwischen dem zweiten Schalter und dem Verbraucher mit dem ersten Potential, beispielsweise wenn der erste und der zweite Schalter geöffnet sind und die Spannung des dritten Potentials gegenüber dem zweiten Potential über dem ersten Spannungsschwellenwert liegt, welcher beispielsweise der Spannung des ersten Potentials gegenüber dem zweiten Potential abzüglich eines spannungsteilerspezifischen Spannungsabfalls entspricht.

Zwischen drittem Potential und zweitem Potential kann ein Blindwiderstand angeordnet sein.

Der Spannungsteiler ist so dimensioniert, dass ein durch den parallel zum zweiten Schalter liegenden Spannungsteiler sowie den gegebenenfalls zwischen drittem und zweitem Potential angeordneten Blindwiderstand fließender Strom nicht ausreicht, um den elektrischen Verbraucher wenigstens augenscheinlich erkennbar zu betreiben, dieser also ausgehend von durch geöffneten ersten und zweiten Schalter vorliegenden Ruhezustand bzw. ausgeschaltetem Zustand durch Schließen des ersten oder des zweiten Schalters augenscheinlich in ausgeschaltetem Zustand bzw. in Ruhe verbleibt. Beispielsweise bei einem Leuchtmittel, wie etwa einer Leuchtdiode bedeutet dies, dass das Leuchtmittel augenscheinlich erkennbar nicht leuchtet. Beispielsweise bei einem Elektromotor bedeutet dies, dass ein Rotor des Elektromotors sich nicht dreht und in Stillstand verharrt.

Der elektrische Gesamtwiderstand des Spannungsteilers beträgt vorzugsweise 50 kΩ. Besonders bevorzugt beträgt hierzu der ohmsche Widerstand des Spannungsteilers 50 kΩ. Ein solch hoher Widerstand stellt sicher, dass der elektrische Verbraucher durch Abgreifen des dritten Potentials während der Ausfallerkennung in Ruhe verbleibt. Ferner ist so der durch den Spannungsteiler fließende Strom auf einen derart geringen Wert begrenzt, dass praktisch keine Verluste entstehen.

Der elektrische Verbraucher kann ein ohmscher Verbraucher sein oder einen solchen umfassen. Ein ohmscher Verbraucher ist ein elektrischer Verbraucher, dessen elektrischer Widerstand unabhängig von Spannung, Stromstärke und Frequenz ist. An dem ohmschen Verbraucher gilt das ohmsche Gesetz für beliebige Spannungen, Ströme und Frequenzen. In einem Strom-SpannungsDiagramm bildet die über der durch den ohmschen Verbraucher fließende Stromstärke aufgetragene Spannung eine Ursprungsgerade.

Ein als ohmscher Verbraucher ausgeführter elektrischer Verbraucher kann beispielsweise eine oder mehrere in Reihe geschaltete Leuchtdioden umfassen.

Open-Load wird beim ohmschen Verbraucher erkannt, indem der erste Schalter geschlossen und der zweite Schalter geöffnet ist. Liegt die Spannung des dritten Potentials gegenüber dem zweiten Potential unterhalb des vorgegebenen dritten Spannungsschwellenwerts liegt Open-Load vor. Liegt die Spannung des dritten Potentials gegenüber dem zweiten Potential oberhalb des vorgegebenen zweiten Spannungsschwellenwerts liegt kein Open-Load vor und der Anschluss ist in Ordnung.

Alternativ oder zusätzlich kann der elektrische Verbraucher ein induktiver Verbraucher sein oder einen solchen umfassen. Ein induktiver Verbraucher hat eine auch als Eigeninduktivität, Selbstinduktivität oder Selbstinduktion bezeichnete elektrische Eigenschaft, bei einer Änderung des durch den induktiven Verbraucher hindurch fließenden elektrischen Stroms ein Magnetfeld zu erzeugen, welches Magnetfeld der Stromänderung entgegenwirkt.

Ein als induktiver Verbraucher ausgeführter elektrischer Verbraucher kann beispielsweise einen oder mehrere Elektromotoren umfassen.

Open-Load wird bei einem induktiven Verbraucher durch Beobachtung einer Veränderung der Spannung des dritten Potentials gegenüber dem zweiten Potential bei Veränderung des Stroms durch den elektrischen Verbraucher hervorgerufen beispielsweise durch Schließen oder Öffnen des ersten oder zweiten Schalters erkannt. Beispielsweise liegt Open-Load dann vor, wenn bei geöffnetem zweiten Schalter der erste Schalter geschlossen wird und die Spannung des dritten Potentials gegenüber dem zweiten Potential bei einem anschließenden Öffnen des ersten Schalters unverändert bleibt, wohingegen der Anschluss in Ordnung ist und kein Open-Load vorliegt, wenn wiederum ausgehend von geöffnetem zweiten Schalter der erste Schalter geschlossen wird und die Spannung des dritten Potentials gegenüber dem zweiten Potential bei einem anschließenden Öffnen des ersten Schalters zumindest kurzzeitig zunimmt.

Der erste Schalter umfasst eine Stromüberwachungsschaltung. Der erste Schalter ist ein so genannter intelligenter Schalter mit einer Stromüberwachungsschaltung. Die Stromüberwachungsschaltung umfasst eine Überstromabschaltung. Ein verbraucherseitiger Kurzschluss des ersten Schalters mit dem zweiten Potential wird hierbei durch eine Überstromabschaltung der Stromüberwachungsschaltung bei betätigtem ersten Schalter und unbetätigtem zweiten Schalter erkannt. Ebenfalls wird mittels der Überstromabschaltung der Stromüberwachungsschaltung bei geschlossenem ersten und zweiten Schalter ein Kurzschluss zwischen dem ersten und dem zweiten Schalter erkannt. Die Überstromabschaltung erfolgt dabei in beiden Fällen bei Überschreitung des Stromschwellenwerts.

Mehrere elektrische Verbraucher können in mehreren jeweils einen ersten Schalter umfassenden parallelen Zweigen über einen gemeinsamen zweiten Schalter mit dem zweiten Potential schaltbar verbunden sein. Die Ausfallerkennung der verschiedenen Ausfallarten erfolgt dabei sequentiell von Zweig zu Zweig. Dabei ist denkbar, dass unterschiedliche elektrische Verbraucher, beispielsweise unterschiedliche Arten von elektrischen Verbrauchern, wie etwa ohmsche Verbraucher und induktive Verbraucher, in den unterschiedlichen Zweigen angeordnet sind. Den einzelnen Zweigen können dabei unterschiedliche Strom- und/oder Spannungsschwellenwerte zugeordnet sein.

Weitere Merkmale der Erfindung ergeben sich aus den weiteren Ansprüchen, der Beschreibung und den Zeichnungen.

Die Erfindung wird nachstehend anhand von in den Zeichnungen dargestellten Ausführungsbeispielen näher erläutert. Darin bezeichnen gleiche Bezugszeichen gleiche oder gleich wirkende Elemente. Es zeigen:
- Fig. 1: eine schematische Darstellung einer Schaltungsanordnung eines ersten Ausführungsbeispiels einer Ausfallerkennung.
- Fig. 2: eine schematische Darstellung einer Schaltungsanordnung eines zweiten Ausführungsbeispiels einer Ausfallerkennung.

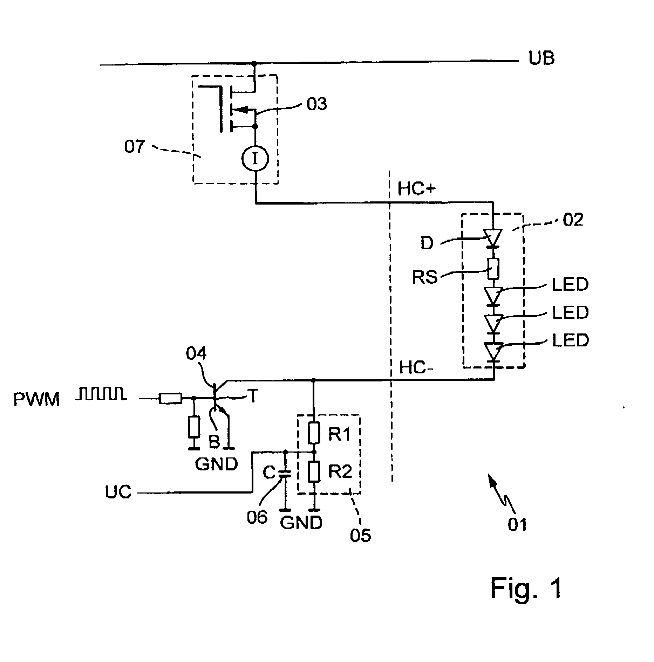

Eine erfindungsgemäße Ausfallerkennung wird beispielsweise durch eine in Fig. 1 dargestellte Schaltungsanordnung 01 verwirklicht. Die Schaltungsanordnung 01 dient der Ausfallerkennung mehrerer als Lichtquelle für eine Leuchtfunktion eines nicht näher dargestellten Kraftfahrzeugs vorgesehener, als Leuchtdioden LED ausgeführter Leuchtmittel. Drei Leuchtdioden LED sind zu einem Zweig 02 in Reihe geschaltet. In dem Zweig 02 kann eine Schutzschaltung integriert sein bestehend aus einer Sperrdiode D und einem Schutzwiderstand RS. Der Zweig 02 der Schaltungsanordnung 01 steht stellvertretend für einen beliebigen elektrischen Verbraucher in einem Stromkreis. Der Zweig 02 ist schaltbar zwischen einem ersten elektrischen Potential UB, beispielsweise einer Bordnetzversorgungsspannung, und einem zweiten elektrischen Potential GND, beispielsweise Bordnetzmasse, angeordnet. Der Zweig 02 ist sowohl mit dem ersten Potential UB, als auch mit dem zweiten Potential GND schaltbar verbunden. Ein erster Schalter 03 ist zwischen dem ersten Potential UB und dem Zweig 02 angeordnet und ein zweiter Schalter 03 ist zwischen dem zweiten Potential GND und dem Zweig 02 angeordnet. Zum Betrieb der Leuchtdioden LED des Zweigs 02 müssen der erste Schalter 03 und der zweite Schalter 04 gleichzeitig geschlossen bzw. betätigt sein. Der zweite Schalter 04 kann als ein Transistor T ausgeführt sein, dessen Basis B beispielsweise mittels eines schematisch dargestellten pulsweitenmodulierten Schaltsignals PWM beaufschlagt werden kann. Je nach Pulsweite kann bei geschlossenem ersten Schalter 03 die Leuchtstärke der Leuchtdioden LED des Zweigs 02 stufenlos vom Ruhezustand ausgehend bis zur höchstmöglichen Leistungsaufnahme und Leuchtstärke in eingeschaltetem Zustand geregelt werden.

Die Ausfallerkennung erfolgt in augenscheinlich ausgeschaltetem Zustand des Zweigs 02, in welchem die Leuchtdioden LED für das menschliche Auge nicht oder nicht erkennbar leuchten. Parallel zum zweiten Schalter 04 ist hierzu ein Spannungsteiler 05 angeordnet. Er besteht beispielsweise aus zwei in Reihe geschalteten ohmschen Widerständen R1 und R2. Vorzugsweise hat der sich aus den Einzelwiderständen der ohmschen Widerstände R1 und R2 ergebende ohmsche Widerstand des Spannungsteilers 05 eine Größenordnung von 10⁴ bis 10⁵ Ω, beispielsweise 50 kΩ. Dadurch ist ein zwischen erstem Potential UB und zweitem Potential GND durch den Zweig 02 fließender Strom so klein, dass die Leuchtdioden LED des Zweigs 02 nicht bzw. für das menschliche Auge nicht erkennbar leuchten und zumindest augenscheinlich in ausgeschaltetem Zustand bzw. Ruhezustand verweilen. Ein drittes elektrisches Potential UC wird am Spannungsteiler 05 abgegriffen. Zwischen drittem Potential UC und zweitem Potential GND kann ein beispielsweise durch einen Kondensator C gebildeter Blindwiderstand 06 angeordnet sein.

Der erste Schalter 03 kann eine Stromüberwachungsschaltung I mit einer Überstromabschaltung umfassen. Beispielsweise kann der erste Schalter 03 Teil eines intelligenten Schalters 07 sein, welcher die Stromüberwachungsschaltung I mit Überstromabschaltung umfasst.

Die Ausfallerkennung erfolgt durch Beobachtung des dritten elektrischen Potentials UC und der Stellungen des ersten Schalters 03 und des zweiten Schalters 04.

Die Ausfallerkennung kann die unterschiedlichen Ausfallarten
a) Open-Load,
b) verbraucherseitiger Kurzschluss des ersten Schalters 03 mit dem zweiten Potential GND,
c) Kurzschluss zwischen dem ersten Schalter 03 und dem zweiten Schalter 04,
d) verbraucherseitiger Kurzschluss des ersten Schalters 03 mit dem ersten Potential UB,
e) verbraucherseitiger Kurzschluss des zweiten Schalters 04 mit dem zweiten Potential GND, und
f) verbraucherseitiger Kurzschluss des zweiten Schalters 04 mit dem ersten Potential UB
identifizieren.

Ein verbraucherseitiger Kurzschluss des ersten Schalters 03 mit dem zweiten Potential GND bzw. ein Kurzschluss der mit HC+ gekennzeichneten Verbindung zwischen dem ersten Schalter 03 und dem Zweig 02 mit dem zweiten Potential GND kann beispielsweise dadurch erkannt werden, wenn ein bei geschlossenem ersten Schalter 03 durch den ersten Schalter 03 bzw. durch dessen Stromüberwachungsschaltung I fließender Strom einen vorgegebenen Stromschwellenwert übersteigt, unabhängig von der Stellung des zweiten Schalters 04. Der mittels der Stromüberwachungsschaltung I gemessene Strom übersteigt dabei sowohl bei geöffnetem, als auch bei geschlossenem zweitem Schalter 04 den vorgegebenen Stromschwellenwert. Bevorzugt wird deshalb der zweite Schalter 04 beispielsweise wiederholt geöffnet und geschlossen, wenn der von der Stromüberwachungsschaltung I gemessene Strom den Stromschwellenwert übersteigt. Bleibt der von der Stromüberwachungsschaltung I gemessene Strom sowohl bei geöffnetem, als auch bei geschlossenen zweiten Schalter 04 größer als der vorgegebene Stromschwellenwert, liegt ein Kurzschluss der Verbindung HC+ mit dem zweiten Potential vor. Durch die Stromüberwachungsschaltung I mit Überstromabschaltung kann ein verbraucherseitiger Kurzschluss des ersten Schalters 03 mit dem zweiten Potential GND auch durch eine Überstromabschaltung des intelligenten Schalters 07 bei betätigtem ersten Schalter 03 und unbetätigtem zweiten Schalter 04 erkannt werden.

Ein Kurzschluss zwischen dem ersten Schalter 03 und dem zweiten Schalter 04 bzw. ein Kurzschluss der mit HC+ gekennzeichneten Verbindung zwischen dem ersten Schalter 03 und dem Zweig 02 mit der mit HC- gekennzeichneten Verbindung zwischen dem zweiten Schalter 04 und dem Zweig 02 kann beispielsweise erkannt werden, wenn bei geschlossenem ersten Schalter 03 und geschlossenem zweiten Schalter 04 ein durch den ersten Schalter 03 bzw. durch die Stromüberwachungsschaltung I des ersten Schalters 03 fließender Strom den vorgegebenen Stromschwellenwert übersteigt. Beispielsweise kann ein Kurzschluss zwischen dem ersten Schalter 03 und dem zweiten Schalter 04 ebenfalls mittels der Überstromabschaltung der Stromüberwachungsschaltung I des intelligenten Schalters 07 bei geschlossenem ersten Schalter 03 und geschlossenem zweiten Schalter 04 erkannt werden. Alternativ oder zusätzlich kann ein Kurzschluss zwischen dem ersten Schalter 03 und dem zweiten Schalter 04 erkannt werden, wenn bei geschlossenem ersten Schalter 03 und bei geöffnetem zweiten Schalter 04 die Spannung des dritten Potentials UC gegenüber dem zweiten Potential GND über einem vorgegebenen ersten Spannungsschwellenwert liegt, welcher beispielsweise der Spannung des ersten Potentials UB gegenüber dem zweiten Potential GND abzüglich eines verbraucherspezifischen Mindestspannungsabfalls entsprechen kann. Beispielsweise bei Leuchtdioden LED beträgt der Mindestspannungsabfall 1,7 V je Leuchtdiode LED, die Schutzdiode D hat einen Mindestspannungsabfall von beispielsweise 0,3 V bis 0,7 V. Der verbraucherspezifische Mindestspannungsabfall kann beispielsweise 5 V betragen. Durch eine Überwachung der Bordnetzspannung, welche der Spannung des ersten Potentials UB gegenüber dem zweiten Potential GND entspricht, kann der erste Spannungsschwellenwert dynamisch an Bordnetzspannungsschwankungen angepasst werden.

Ein verbraucherseitiger Kurzschluss des ersten Schalters 03 mit dem ersten Potential UB bzw. ein Kurzschluss der Verbindung HC+ zwischen dem ersten Schalter 03 und dem Zweig 02 mit dem ersten Potential UB kann erkannt werden, wenn bei geöffnetem ersten Schalter 03 und geöffnetem zweiten Schalter 04 die Spannung des dritten Potentials UC gegenüber dem zweiten Potential GND über einem vorgegebenen zweiten Spannungsschwellenwert liegt, welcher beispielsweise der Spannung des ersten Potentials UB gegenüber dem zweiten Potential GND abzüglich eines verbraucherspezifischen Spannungsabfalls und abzüglich einem spannungsteilerspezifischen Spannungsabfall entspricht. Ein typischer Wert für den zweiten Spannungsschwellenwert liegt bei Kraftfahrzeuganwendungen beispielsweise 3,5 V, bei Nutzfahrzeuganwendungen kann der Wert höher liegen. Auch der zweite Spannungsschwellenwert kann durch eine Überwachung der Bordnetzspannung dynamisch an Bordnetzspannungsschwankungen angepasst werden.

Ein verbraucherseitiger Kurzschluss des zweiten Schalters 04 mit dem zweiten Potential GND bzw. ein Kurzschluss der Verbindung HC- zwischen dem zweiten Schalter 04 und dem Zweig 02 mit dem zweiten Potential GND kann beispielsweise erkannt werden, wenn der erste Schalter 03 geschlossen und der zweite Schalter 04 geöffnet ist und die Spannung des dritten Potentials UC gegenüber dem zweiten Potential GND unterhalb einem vorgegebenen dritten Spannungsschwellenwert liegt. Ein typischer Wert für den dritten Spannungsschwellenwert liegt bei Kraftfahrzeuganwendungen beispielsweise 1,0 V, bei Nutzfahrzeuganwendungen kann der Wert wiederum höher liegen. Die Stromüberwachungsschaltung I des ersten Schalters weist hierbei weder auf einen Open-Load-Zustand hin, noch misst sie einen den vorgegebenen Stromschwellenwert übersteigenden Strom. Bei intaktem elektrischem Verbraucher bzw. bei intakten Leuchtdioden LED im Zweig 02, wird dieser unabhängig davon, ob der zweite Schalter 04 geöffnet oder geschlossen ist, bei geschlossenem ersten Schalter in Betriebszustand gehen bzw. werden die Leuchtdioden LED leuchten.

Ein verbraucherseitiger Kurzschluss des zweiten Schalters 04 mit dem ersten Potential UB bzw. ein Kurzschluss der Verbindung HC- zwischen dem zweiten Schalter 04 und dem Zweig 02 mit dem ersten Potential UB kann erkannt werden, wenn sowohl der erste Schalter 03, als auch der zweite Schalter 04 geöffnet sind und die Spannung des dritten Potentials UC gegenüber dem zweiten Potential GND über dem ersten Spannungsschwellenwert liegt.

Nachdem es sich bei dem Leuchtdioden LED, eine Schutzdiode D und einen Schutzwiderstand RS umfassenden Zweig 02 um einen ohmschen Verbraucher handelt, bzw. nachdem der Zweig 02 einen ohmschen Verbraucher umfasst, kann Open-Load erkannt werden, wenn der erste Schalter 03 geschlossen und der zweite Schalter 04 geöffnet ist. Liegt die Spannung des dritten Potentials UC gegenüber dem zweiten Potential GND unterhalb des vorgegebenen dritten Spannungsschwellenwerts liegt Open-Load vor. Liegt die Spannung des dritten Potentials UC gegenüber dem zweiten Potential GND oberhalb des vorgegebenen zweiten Spannungsschwellenwerts liegt kein Open-Load vor und der die Verbindungen HC+ und HC- umfassende Anschluss des den elektrischen Verbraucher im Stromkreis bildenden Zweigs 02 ist in Ordnung. Wichtig ist hervorzuheben, dass bei Open-Load eine im ersten Schalter 03 angeordnete Stromüberwachungsschaltung I weder einen den vorgegebenen Stromschwellenwert übersteigenden Strom, noch den durch den Spannungsteiler 05 fließenden Strom misst.

Der wahlweise mit der Stromüberwachungsschaltung I ausgestattete und dadurch auch als intelligent bezeichenbare erste Schalter 03 kann im Open-Load-Fall sowohl im übertragenen Sinn, als auch bei einer konkreten Ausgestaltung der Schaltungsanordnung 01 ein z.B. von einer Auswerteschaltung auswertbares Signal ausgeben, das z.B. als so genanntes Flag dienen kann. Das Flag ist bevorzugt gesetzt bei Open-Load und wird nicht ausgegeben, wenn kein Open-Load vorliegt. Alternativ oder zusätzlich ist denkbar, dass der intelligente erste Schalter 03 ein als weiteres Flag dienendes weiteres Signal ausgibt, wenn der von der Stromüberwachungsschaltung I gemessene Strom den vorgegebenen Stromschwellenwert übersteigt.

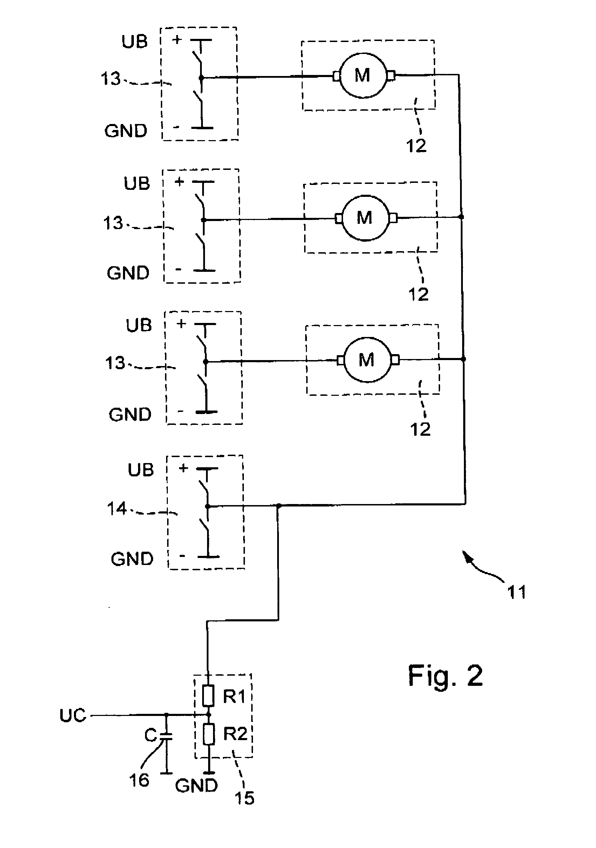

Ganz ähnlich arbeitet eine in Fig. 2 dargestellt Schaltungsanordnung 11, mit der ebenfalls eine erfindungsgemäße Ausfallerkennung verwirklicht wird.

Bei der Schaltungsanordnung 11 sind mehrere durch Elektromotoren M gebildete elektrische Verbraucher in mehreren jeweils einen ersten Schalter 13 umfassenden parallelen Zweigen 12 über einen gemeinsamen zweiten Schalter 14 mit einem ersten Potential UB, beispielsweise einer Bordnetzversorgungsspannung, und mit einem zweiten Potential GND, beispielsweise einer Bordnetzmasse, schaltbar verbunden.

Bei den ersten Schaltern 13 handelt es sich jeweils um Mehrwegeschalter, welche jeweils eine Verbindung mit dem ersten Potential UB oder mit dem zweiten Potential GND herstellen können. Auch bei dem gemeinsamen zweiten Schalter 14 handelt es sich um einen Mehrwegeschalter, der wahlweise eine Verbindung mit dem zweiten Potential GND oder mit dem ersten Potential UB herstellen kann. Dadurch ist eine Laufrichtungsumkehr der Elektromotoren M in den einzelnen Zweigen 12 möglich.

Zum Betrieb der Elektromotoren M der einzelnen Zweige 12 müssen der erste Schalter 13 des jeweiligen Zweigs 12 und der zweite Schalter 14 gleichzeitig geschlossen bzw. betätigt sein. Je nach gewünschter Laufrichtung des Elektromotors M stellt dabei der jeweilige erste Schalter 13 eine Verbindung mit einem der beiden Potentiale UB oder GND her und der zweite Schalter 14 mit dem jeweils anderen Potential GND oder UB.

Die Ausfallerkennung erfolgt in augenscheinlich ausgeschaltetem Zustand bzw. Ruhezustand der Elektromotoren M in den jeweiligen Zweigen 12. Im Ruhezustand dreht sich der Rotor eines Elektromotors M dabei nicht und verharrt in Stillstand.

Parallel zum zweiten Schalter 14 ist auch bei der Schaltungsanordnung 11 ein Spannungsteiler 15 angeordnet. Auch dieser kann wie schematisch dargestellt aus zwei in Reihe geschalteten ohmschen Widerständen R1 und R2 bestehen. Wiederum kann der sich durch Addition der Einzelwiderstände der ohmschen Widerstände R1 und R2 ergebende ohmsche Widerstand des Spannungsteilers 15 eine Größenordnung von 10⁴ bis 10⁵ Ω, beispielsweise von 50 kΩ betragen. Bei Elektromotoren M, insbesondere bei leistungsstarken Elektromotoren M kann der ohmsche Widerstand des Spannungsteilers 15 eine Größenordnung darunter liegen. Dadurch ist sichergestellt, dass ein zwischen erstem Potential UB und zweitem Potential GND durch einen Zweig 12 fließender Strom so klein, dass die Elektromotoren M der einzelnen Zweige 12 selbst bei mit dem ersten Potential UB geschlossenen ersten Schaltern 14 und geöffnetem zweiten Schalter 14 in Ruhezustand verweilen.

Auch bei der Schaltungsanordnung 11 in Fig. 2 wird wie bei der Schaltungsanordnung 01 in Fig. 1 ein drittes elektrisches Potential UC am Spannungsteiler 15 abgegriffen. Zwischen drittem Potential UC und zweitem Potential GND kann ebenfalls ein beispielsweise durch einen Kondensator C gebildeter Blindwiderstand 16 angeordnet sein. Der bevorzugt als Kondensator C ausgeführte Blindwiderstand 16 dient als Filterelement, im Ausführungsbeispiel als Tiefpassfilterelement.

Allgemein ist vorzugsweise ein Filterelement vorgesehen, das vorzugsweise als Tiefpassfilterelement arbeitet und beispielsweise wie in den Ausführungsbeispielen in Fig. 1 und 2 als ein zwischen drittem Potential UC und zweitem Potential GND angeordneter Kondensator C, beispielsweise als eine vor dem Spannungsteiler 05, 15 oder zwischen Spannungsteiler 05, 15 und drittem Potential angeordnete Induktivität oder beispielsweise als Kombination hieraus ausgeführt sein kann.

Die Ausfallerkennung erfolgt auch bei der Schaltungsanordnung 11 in Fig. 2 wie bei der Schaltungsanordnung 01 in Fig. 1 durch Beobachtung des dritten elektrischen Potentials UC und der Stellungen der ersten Schalter 13 und des zweiten Schalters 14. Die Ausfallerkennung der verschiedenen Ausfallarten erfolgt dabei sequentiell von Zweig 12 zu Zweig 12.

Auch die durch die Schaltungsanordnung 11 verwirklichte Ausfallerkennung kann die unterschiedlichen Ausfallarten
a) Open-Load,
b) verbraucherseitiger Kurzschluss des ersten Schalters 03 mit dem zweiten Potential GND,
c) Kurzschluss zwischen dem ersten Schalter 03 und dem zweiten Schalter 04,
d) verbraucherseitiger Kurzschluss des ersten Schalters 03 mit dem ersten Potential UB,
e) verbraucherseitiger Kurzschluss des zweiten Schalters 04 mit dem zweiten Potential GND, und
f) verbraucherseitiger Kurzschluss des zweiten Schalters 04 mit dem ersten Potential UB
identifizieren.

Aufgrund der Ähnlichkeit des Prinzips der Ausfallerkennung der in den Fig. 1 und 2 dargestellten Schaltungsanordnungen 01 und 11 wird auf eine ausführliche Beschreibung der Erkennung der verschiedenen Ausfallarten bei der Schaltungsanordnung 11 verzichtet.

Ein herauszuhebender Unterschied der durch die in Fig. 2 dargestellte Schaltungsanordnung 11 verwirklichten Ausfallerkennung gegenüber der in Fig. 1 dargestellten Schaltungsanordnung 01 ist auf den Umstand zurückzuführen, dass es sich bei den durch Elektromotoren M gebildeten elektrischen Verbrauchern um induktive Verbraucher handelt.

Bei der Schaltungsanordnung 11 mit durch die in den parallelen Zweigen 12 angeordneten Elektromotoren M gebildeten induktiven Verbrauchern wird Open-Load durch Beobachtung einer Veränderung der Spannung des dritten Potentials UC gegenüber dem zweiten Potential GND bei Veränderung des Stroms durch den elektrischen Verbraucher, hier einen Elektromotor M eines Zweigs 12, erkannt. Eine Veränderung des Stroms durch einen Elektromotor M eines Zweigs 12 kann beispielsweise bei geöffnetem zweiten Schalter 14, wenn der zweite Schalter 14 weder eine Verbindung zum ersten Potential UB, noch eine Verbindung mit dem zweiten Potential GND herstellt, durch Schließen und Herstellung einer Verbindung mit dem ersten Potential UB und anschließendes Öffnen eines ersten Schalters 13 eines Zweigs 12 hervorgerufen werden.

Open-Load liegt in diesem Fall dann vor, wenn bei geöffnetem zweiten Schalter 14 ein erster Schalter 13 zur Herstellung einer Verbindung mit dem ersten Potential UB geschlossen wird und die Spannung des dritten Potentials UC gegenüber dem zweiten Potential GND bei einem anschließenden Öffnen des ersten Schalters 13 unverändert bleibt. Der Anschluss des selben Zweigs 12 ist in Ordnung und es liegt kein Open-Load vor, wenn wiederum ausgehend von geöffnetem zweiten Schalter 14 der erste Schalter 13 zur Herstellung einer Verbindung mit dem ersten Potential UB geschlossen wird und die Spannung des dritten Potentials UC gegenüber dem zweiten Potential GND bei einem anschließenden Öffnen des ersten Schalters 13 zumindest kurzzeitig zunimmt.

Um Open-Load unabhängig von der Betätigungsrichtung eines als Mehrwegeschalter ausgeführten ersten Schalters 13 erkennen zu können, kann verbraucherseitig zwischen zweitem Schalter 14 und erstem Potential UB ein ohmscher Widerstand angeordnet sein. Seriell zum ohmschen Widerstand kann bevorzugt ein dritter Schalter angeordnet sein, um Ruhestromverluste zu vermeiden. Ist ein solcher dritter Schalter vorgesehen und dieser geschlossen, hebt der verbraucherseitig zwischen zweitem Schalter 14 und erstem Potential UB angeordnete ohmsche Widerstand bei ausgeschaltetem ersten Schalter 13 und ausgeschaltetem zweiten Schalter 14 das verbraucherseitig des zweiten Schalters 14 herrschende Ruhepotential auf einen Wert zwischen erstem Potential UB und zweitem Potential GND an. Bevorzugt entspricht der ohmsche Widerstand dem Gesamtwiderstand des Spannungsteilers 15. Dadurch entspricht die Potentialanhebung etwa der Hälfte der Spannung zwischen erstem Potential UB und zweitem Potential GND. Durch diese Maßnahme kann unabhängig von der Betätigungsrichtung des als Mehrwegeschalter ausgeführten ersten Schalters 13 z.B. Open-Load erkannt werden. Ohne den verbraucherseitig zwischen zweitem Schalter 14 und erstem Potential UB angeordneten Widerstand entspräche bzw. bei geöffnetem dritten Schalter entspricht das verbraucherseitig des zweiten Schalters 14 herrschende Ruhepotential dem zweiten Potential, da in diesen Fällen der Spannungsteiler 15 das zweite Potential verbraucherseitig des zweiten Schalters 14 als Ruhepotential aufprägt.

Wichtig ist hervorzuheben, dass bei allen Ausführungsbeispielen das dritte Potential UC mit dem Analog-Digital (AD) Eingang eines Mikrocontrollers verbunden werden kann. Ebenso wichtig ist hervorzuheben, dass neben den ersten Schaltern 03, 13 auch die zweiten Schalter 04, 14 als intelligente Schalter mit jeweils einer Stromüberwachungsschaltung I mit Überstromabschaltung ausgeführt sein können. Dadurch lassen sich vor allem bei leistungsstarken elektrischen Verbrauchern, wie etwa Elektromotoren M, die verschiedenen Ausfallarten besser identifizieren. Generell können die elektrischen Verbraucher auch als kapazitive Verbraucher ausgeführt sein oder solche umfassen. Dies gilt vor allem dann, solange ein z.B. durch einen Kondensator gebildeter kapazitiver Verbraucher noch nicht vollständig geladen ist. Beispiele hierfür sind durch Kondensatoren und/oder Akkumulatoren gebildete Leistungspuffer in elektrischen Schaltkreisen. Diese können auch in elektrische Verbraucher integriert sein.

Vorteile der Erfindung gegenüber dem Stand der Technik ergeben sich unter anderem dadurch, dass bei verfügbaren Treiberbausteinen mit Leistungstreibern für diverse Anwendungen benötigte Mindestströme der Applikation zur sicheren Erkennung von Open-Load umgangen werden können. Durch die Erfindung können solche Mindeststromwerte unterschritten werden, ohne Einschränkungen bei der Ausfallerkennung unterschiedlicher Ausfallarten hinnehmen zu müssen.

Die Erfindung ist insbesondere im Bereich der Herstellung von Kontrollschaltungen zur Überwachung elektrischer Verbraucher in Kraftfahrzeugen gewerblich anwendbar.

## Patentansprüche

1. Schaltungsanordnung für eine Ausfallerkennung eines elektrischen Verbrauchers (LED, 02, M, 12) in Kraftfahrzeugen mit mindestens einem schaltbar zwischen einem ersten elektrischen Potential (UB) und einem zweiten elektrischen Potential (GND) angeordneten elektrischen Verbraucher (LED, 02, M, 12), wobei der elektrische Verbraucher (LED, 02, M, 12) sowohl mit dem ersten, als auch mit dem zweiten Potential (UB, GND) schaltbar verbunden ist, wobei ein einen erster Schalter (03, 13) umfassender intelligenter Schalter (07) zwischen dem ersten Potential (UB) und dem Verbraucher (LED, 02, M, 12) und ein zweiter Schalter (04, 14) zwischen dem zweiten Potential (GND) und dem Verbraucher (LED, 02, M, 12) angeordnet ist, wobei zum Betrieb des Verbrauchers (LED, 02, M, 12) der erste und der zweite Schalter (03, 13, 04, 14) geschlossen sind, und wobei die Ausfallerkennung im ausgeschalteten Zustand des Verbrauchers (LED, 02, M, 12) erfolgt und die Stellung des ersten und des zweiten Schalters beobachtbar ist, **gekennzeichnet durch** ein drittes elektrisches Potential an einem parallel zum zweiten Schalter angeordneten Spannungsteiler (05, 15) und **durch** eine im intelligenten Schalter (07) ausgebildete Stromüberwachungsschaltung (I), die eine Überstromabschaltung umfasst, und **dadurch**, dass zur Ausfallerkennung das dritte Potential (UC) und die Stromüberwachungsschaltung (I) beobachtbar sind.

2. Schaltungsanordnung für eine Ausfallerkennung nach Anspruch 1, **dadurch gekennzeichnet, dass**
zwischen drittem Potential (UC) und zweitem Potential (GND) ein Blindwiderstand (06, 16) angeordnet ist.

3. Schaltungsanordnung für eine Ausfallerkennung nach Anspruch 1 oder 2, **dadurch gekennzeichnet, dass**
durch die Ausfallerkennung die unterschiedlichen Ausfallarten:
- Open-Load;
- verbraucherseitiger Kurzschluss des ersten Schalters (03, 13) mit dem zweiten Potential (GND);
- Kurzschluss zwischen dem ersten und dem zweiten Schalter (03, 13, 04, 14);
- verbraucherseitiger Kurzschluss des ersten Schalters (03, 13) mit dem ersten Potential (UB);
- verbraucherseitiger Kurzschluss des zweiten Schalters (04, 14) mit dem zweiten Potential (GND);
- verbraucherseitiger Kurzschluss des zweiten Schalters (04, 14) mit dem ersten Potential (UB); unterscheidbar sind.

4. Schaltungsanordnung für eine Ausfallerkennung nach mindestens einem der vorhergehenden Ansprüche, **dadurch gekennzeichnet, dass** der Spannungsteiler (05, 15) so dimensioniert ist, dass ein durch ihn sowie durch einen gegebenenfalls zwischen drittem und zweitem Potential (UC, GND) angeordneten Blindwiderstand (06, 16) fliessender Strom so gering ist, dass der elektrische Verbraucher (LED, 02, M, 12) ausgehend von einem durch geöffneten ersten und zweiten Schalter (03, 13, 04, 14) vorliegenden Ruhezustand durch Schliessen des ersten Schalters (03, 13) oder des zweiten Schalters (04, 14) in Ruhe verbleibt.

5. Schaltungsanordnung für eine Ausfallerkennung nach Anspruch 4, **dadurch gekennzeichnet, dass**
zumindest der ohmsche Widerstand des Spannungsteilers (05, 15) 50 k[Omega] umfasst.

6. Schaltungsanordnung für eine Ausfallerkennung nach mindestens einem der vorhergehenden Ansprüche, **dadurch gekennzeichnet, dass** der elektrische Verbraucher (LED, 02) ein ohmscher Verbraucher ist oder einen solchen umfasst.

7. Schaltungsanordnung für eine Ausfallerkennung nach Anspruch 6, **dadurch gekennzeichnet, dass**
zur Open-Load-Erkennung der erste Schalter (03) schließbar und der zweite Schalter (04) öffenbar ist, wobei wenn die Spannung des dritten Potentials (UC) gegenüber dem zweiten Potential (GND) niedriger als ein vorgegebener dritter Spannungsschwellenwert ist ein Open-Load erfassbar ist, und wenn die Spannung oberhalb eines vorgegebenen zweiten Spannungsschwellenwerts liegt der Anschluss ein ordnungsgemäßes Funktionieren erfassbar ist.

8. Schaltungsanordnung für eine Ausfallerkennung nach mindestens einem der vorhergehenden Ansprüche, **dadurch gekennzeichnet, dass** der elektrische Verbraucher (M, 12) ein induktiver Verbraucher ist oder einen solchen umfasst.

9. Schaltungsanordnung für eine Ausfallerkennung nach Anspruch 8, **dadurch gekennzeichnet, dass**
zur Open-Load-Erkennung eine Veränderung der Spannung des dritten Potentials (UC) gegenüber dem zweiten Potential (GND) bei einer Veränderung des Stroms durch den elektrischen Verbraucher (M, 12) beobachtbar ist.

10. Schaltungsanordnung für eine Ausfallerkennung nach mindestens einem der vorhergehenden Ansprüche, **dadurch gekennzeichnet, dass** mehrere elektrische Verbraucher (M) in mehreren jeweils einen ersten Schalter (13) umfassenden parallelen Zweigen (12) über einen gemeinsamen zweiten Schalter (14) mit dem zweiten Potential GND) schaltbar verbindbar ist.

## Claims

1. A circuit arrangement for malfunction recognition of an electricity consumer (LED, 02, M, 12) in motor vehicles having at least one electricity consumer (LED, 02, M, 12) that is switchably arranged between a first electric potential (UB) and a second electric potential (GND), wherein the electricity consumer (LED, 02, M, 12) is switchably connected to both the first potential and the second potential (UB, GND), wherein an intelligent switch (07) comprising a first switch (03, 13) is arranged between the first potential (UB) and the consumer (LED, 02, M, 12) and a second switch (04, 14) is arranged between the second potential (GND) and the consumer (LED, 02, M, 12), wherein the first switch and the second switch (03, 13, 04, 14) are closed for operating the consumer (LED, 02, M, 12), and wherein malfunction recognition is performed in the off state of the consumer (LED, 02, M, 12) and the position of the first switch and the second switch can be observed, **characterized by** a third electric potential at a voltage divider (05, 15) that is arranged parallel to the second switch and by a current monitoring circuit (I) that is provided in the intelligent switch (07) and comprises an overcurrent cutoff, and in that the third potential (UC) and the current monitoring circuit (I) can be observed for malfunction recognition.

2. A circuit arrangement for malfunction recognition according to claim 1, **characterized in that**
a reactance (06, 16) is arranged between the third potential (UC) and the second potential (GND).

3. A circuit arrangement for malfunction recognition according to claim 1 or 2, **characterized in that**
a distinction between the following different malfunction types can be made by performing said malfunction recognition:
• open load;
• consumer-side short circuit of the first switch (03, 13) with the second potential (GND);
• short circuit between the first switch and the second switch (03, 13, 04, 14);
• consumer-side short circuit of the first switch (03, 13) with the first potential (UB);
• consumer-side short circuit of the second switch (04, 14) with the second potential (GND);
• consumer-side short circuit of the second switch (04, 14) with the first potential (UB).

4. A circuit arrangement for malfunction recognition according to at least one of the preceding claims, **characterized in that**
the voltage divider (05, 15) is dimensioned such that a current flowing through said voltage divider as well as through a reactance (06, 16) that is arranged between the third potential and the second potential (UC, GND), if applicable, is so low that the electricity consumer (LED, 02, M, 12), if in a quiescent state because the first switch and the second switch (03, 13, 04, 14) are open, remains in a quiescent state when the first switch (03, 13) or the second switch (04, 14) is closed.

5. A circuit arrangement for malfunction recognition according to claim 4, **characterized in that**
at least the ohmic resistance of the voltage divider (05, 15) comprises 50 k[Omega].

6. A circuit arrangement for malfunction recognition according to at least one of the preceding claims, **characterized in that**
the electricity consumer (LED, 02) is an ohmic consumer or comprises an ohmic consumer.

7. A circuit arrangement for malfunction recognition according to claim 6, **characterized in that**
the first switch (03) can be closed and the second switch (04) can be opened for open-load recognition, wherein an open load can be detected if the voltage of the third potential (UC) is below a predetermined third voltage threshold value as against the second potential (GND), and proper functioning can be detected if the voltage is above a predetermined second voltage threshold value.

8. A circuit arrangement for malfunction recognition according to at least one of the preceding claims, **characterized in that**
the electricity consumer (M, 12) is an inductive consumer or comprises an inductive consumer.

9. A circuit arrangement for malfunction recognition according to claim 8, **characterized in that**
a change in the voltage of the third potential (UC) as against the second potential (GND) with a change in the current flowing through the electricity consumer (M, 12) can be observed for open-load recognition.

10. A circuit arrangement for malfunction recognition according to at least one of the preceding claims, **characterized in that**
several electricity consumers (M) in several parallel branches (12), each of which comprises a first switch (13), can be switchably connected to the second potential (GND) by means of a shared second switch (14).

## Revendications

1. Agencement de circuit pour une reconnaissance de défaillance d'un consommateur électrique (LED, 02, M, 12) sur des véhicules automobiles comprenant au moins un consommateur (LED, 02, M, 12) électrique, disposé de façon commutable entre un premier potentiel électrique (UB) et un second potentiel électrique (GND), le consommateur électrique (LED, 02, M, 12) étant relié de façon commutable aussi bien au premier qu'au second potentiel (UB, GND), un interrupteur (07) intelligent, comprenant un premier interrupteur (03, 13), étant disposé entre le premier potentiel (UB) et le consommateur (LED, 02, M, 12) et un second interrupteur (04, 14) entre le second potentiel (GND) et le consommateur (LED, 02, M, 12), le premier et le second interrupteur (03, 13, 04, 14) étant fermés pour le fonctionnement du consommateur (LED, 02, M, 12), et la reconnaissance de défaillance s'effectuant lorsque le consommateur (LED, 02, M, 12) est dans l'état déconnecté et la position du premier et du second interrupteur peut être observée, **caractérisé par** un troisième potentiel électrique sur un diviseur de tension (05, 15) disposé parallèlement au second interrupteur et par un circuit de contrôle de courant (I) conçu dans l'interrupteur (07) intelligent, lequel circuit comprend une déconnexion de surintensité, et par le fait que le troisième potentiel (UC) et le circuit de contrôle de courant (I) peuvent être observés pour la reconnaissance de défaillance.

2. Agencement de circuit pour une reconnaissance de défaillance selon la revendication 1, **caractérisé en ce**
**qu'**une réactance (06, 16) est disposée entre le troisième potentiel (UC) et le second potentiel (GND).

3. Agencement de circuit pour une reconnaissance de défaillance selon la revendication 1 ou 2, **caractérisé en ce que**
la reconnaissance de défaillance permet de différencier les différents types de défaillance suivants :
- Open-Load ;
- court-circuit côté consommateur du premier interrupteur (03, 13) avec le second potentiel (GND) ;
- court-circuit entre le premier et le second interrupteur (03, 13, 04, 14) ;
- court-circuit côté consommateur du premier interrupteur (03, 13) avec le premier potentiel (UB) ;
- court-circuit côté consommateur du second interrupteur (04, 14) avec le second potentiel (GND) ;
- court-circuit côté consommateur du second interrupteur (04, 14) avec le premier potentiel (UB).

4. Agencement de circuit pour une reconnaissance de défaillance selon au moins l'une des revendications précédentes, **caractérisé en ce que**
le diviseur de tension (05, 15) est dimensionné de telle sorte qu'un courant circulant dans le diviseur et dans une réactance (06, 16) disposée éventuellement entre le troisième et le second potentiel (UC, GND) est si faible que le consommateur électrique (LED, 02, M, 12) reste au repos à partir d'un état de repos présent par le premier et le second interrupteurs (03, 13, 04, 14) ouverts et par la fermeture du premier interrupteur (03, 13) ou du second interrupteur (04, 14).

5. Agencement de circuit pour une reconnaissance de défaillance selon la revendication 4, **caractérisé en ce que**
au moins la résistance ohmique du diviseur de tension (05, 15) comprend 50 k[Omega].

6. Agencement de circuit pour une reconnaissance de défaillance selon au moins l'une des revendications précédentes, **caractérisé en ce que**
le consommateur électrique (LED, 02) est un consommateur ohmique ou comprend un consommateur de ce type.

7. Agencement de circuit pour une reconnaissance de défaillance selon la revendication 6, **caractérisé en ce que**
pour la reconnaissance de l'Open-Load, le premier interrupteur (03) peut être fermé et le second interrupteur (04) peut être ouvert, sachant que, lorsque la tension du troisième potentiel (UC) par rapport au second potentiel (GND) est plus faible qu'une troisième valeur seuil de tension prédéfinie, on peut enregistrer un Open-Load, et lorsque la tension est supérieure à une seconde valeur seuil de tension prédéfinie, un fonctionnement correct peut être enregistré.

8. Agencement de circuit pour une reconnaissance de défaillance selon au moins l'une des revendications précédentes, **caractérisé en ce que**
le consommateur électrique (M, 12) est un consommateur inductif ou comprend un consommateur de ce type.

9. Agencement de circuit pour une reconnaissance de défaillance selon la revendication 8, **caractérisé en ce que**,
pour la reconnaissance de l'Open-Load, on peut observer une variation de la tension du troisième potentiel (UC) par rapport au second potentiel (GND) lors d'une variation du courant passant par le consommateur électrique (M, 12).

10. Agencement de circuit pour une reconnaissance de défaillance selon au moins l'une des revendications précédentes, **caractérisé en ce que**
plusieurs consommateurs électriques (M) peuvent être reliés de façon commutable dans plusieurs branches (12) parallèles et comprenant chacune un premier interrupteur (13) au moyen d'un second interrupteur (14) commun au second potentiel (GND).
